## Europäisches Patentamt

## European Patent Office

## Office européen des brevets

(11) Veröffentlichungsnummer: **0 149 004**

**A2**

(12) **EUROPÄISCHE PATENTANMELDUNG**

(21) Anmeldenummer: **84111203.0**

(22) Anmeldetag: **20.09.84**

(51) Int. Cl.⁴: **B 23 K 15/00**

(30) Priorität: **24.10.83 DE 3338573**

(43) Veröffentlichungstag der Anmeldung:
**24.07.85 Patentblatt 85/30**

(84) Benannte Vertragsstaaten:
**FR GB**

(71) Anmelder: **MESSER GRIESHEIM GMBH**
**Hanauer Landstrasse 330**
**D-6000 Frankfurt/Main 1(DE)** •

(72) Erfinder: **Anderl, Peter**
**Fodermayrstrasse 20**
**D-8000 München 50(DE)**

(72) Erfinder: **Scheffels, Wilhelm, Dr.**
**Dorfstrasse 20**
**D-8031 Puchheim(DE)**

(54) **Verfahren und Vorrichtung zur Magnetfeldabschirmung beim Elektronenstrahlbearbeiten.**

(57) Zur Vermeidung von Schweißfehlern wird ein Verfahren zur Magnetfeldabschirmung am Werkstück beim Elektronenstrahlbearbeiten vorgeschlagen, bei dem in geringem Abstand einerseits von der vom Elektronenstrahl getroffenen Werkstückoberfläche und andererseits vom Elektronenstrahl eine Platte aus ferromagnetischem Material angeordnet wird.

Wasserkühlung

FIG. 4

MESSER GRIESHEIM GMBH                          MG 1439


Kennwort: Magnetfeldabschirmung               EM 1115


Erfinder: P. Anderl                           Ordner: XXII
          Dr. Scheffels


Verfahren und Vorrichtung zur Magnetfeldabschirmung beim
Elektronenstrahlbearbeiten

Die vorliegende Erfindung betrifft ein Verfahren und eine
Vorrichtung zur Magnetfeldabschirmung beim Elektronenstrahlbearbeiten, insbesondere Elektronenstrahlschweißen.

Beim Elektronenstrahlschweißen sind Fehler in der Schweißnaht
insbesondere Bindefehler möglich infolge von Magnetfeldern,
die im Innern des Werkstücks entstehen (z. B. auch während
des Schweißvorgangs und durch diesen erst verursacht) und von
der Werkstückoberfläche sich in den Raum davor ausbreiten.

Aufgabe der Erfindung ist es daher, diese Schweißfehler zu
vermeiden und ein Verfahren/Vorrichtung zur Magnetfeldabschirmung zu schaffen.

Diese Aufgabe wird durch die im Anspruch 1 angegebenen Merkmale gelöst. Weitere vorteilhafte Merkmale sind in den Unteransprüchen sowie der Beschreibung aufgeführt.

Gemäß der Erfindung wird der Einfluß magnetischer Störfelder
auf den Strahl dadurch so gering wie möglich, da*in geringem
erfindungsgemäß
Abstand von der - vom Strahl getroffenen - Oberfläche ein

- 2 -

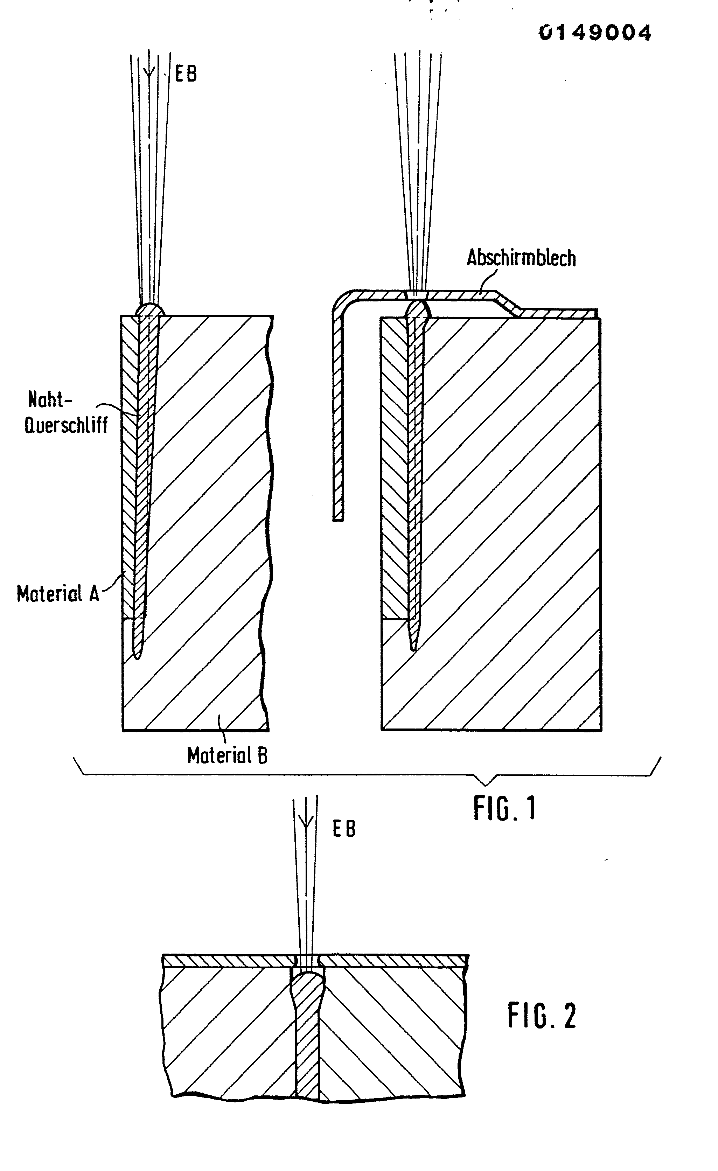

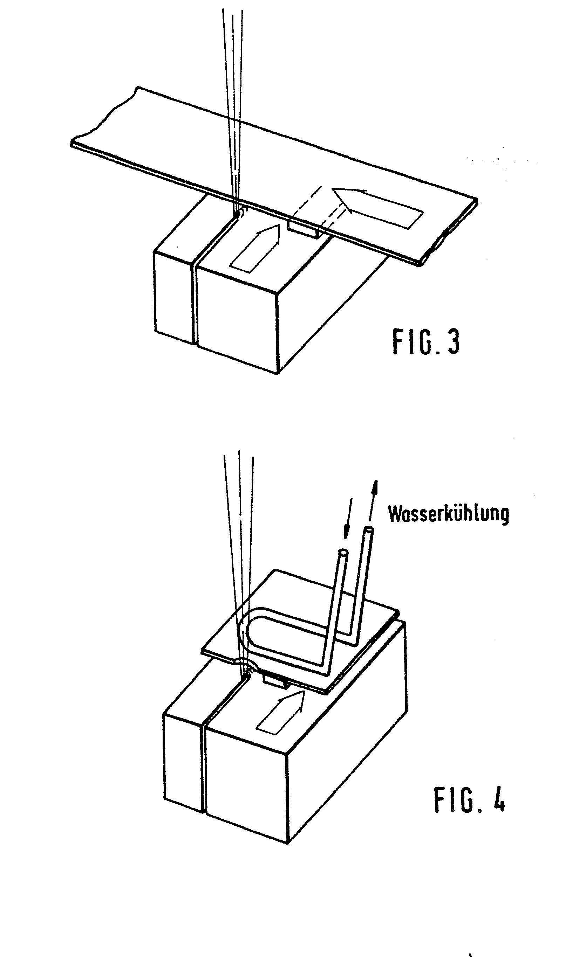

Blech bzw. eine Platte aus ferromagnetischem (magnetisch möglichst weichem) Material angeordnet wird. Dabei kann der Elektronenstrahl die Platte durchdringen, bevor er auf das Werkstück auftrifft. Falls dabei diese Platte aufschmilzt und ihr Material in das Schweißbad tropfen kann, wird das Material der Abschirmplatte so ausgesucht, daß durch ihr Einlegieren in die Schweißnaht sich deren Eigenschaften nicht verschlechtern. In den Figuren 1 bis 4 sind vorteilhafte Ausführungsbeispiele veranschaulicht.

Gemäß Fig. 1 wird eine Platte aus 2 mm dickem Stahl in 5 mm Abstand oberhalb der zu verschweißenden Fuge auf dem Werkstück so befestigt, daß es mindestens an einer Seite der Fuge in z. B. 30 mm seitlichem Abstand von dieser magnetischen Kontakt zum Werkstück hat. Am Anfang und Ende der Schweißprobe ragt die Platte mindestens 30 mm über die Schweißprobe hinaus.

Der Abschirmeffekt ist um so vollständiger, je näher das Blech an der Werkstückoberfläche angebracht werden kann, ohne mit diesem fest verschweißt zu werden. Von Vorteil ist, entsprechend dem Beispiel gemäß Fig. 2, eine Einsenkung der Schweißnaht in einer Nut, so daß die Abschirmung auf dem ebenen Teil der Werkstückoberfläche fest aufliegt.

Um ein Verschmelzen der Abschirmplatte mit dem Werkstück zu vermeiden, wird ferner vorgeschlagen, die Platte unmittelbar hinter dem Strahl (in Schweißrichtung gesehen) angeordnet und gegenüber dem Werkstück quer zur Schweißrichtung so schnell bewegt, daß sie nicht aufschmilzt unter der Wirkung des Schweißbades.

Bei nicht zu großer Strahlleistung und kleiner Schweißlänge kann es auch ausreichend sein, wenn das Abschirmblech fest in der Kammer angeordnet ist und sich das Werkstück unter ihm bewegt (Fig. 4). Für lange Schweißzeiten ist die Ausführung des Blechs

...

0149004

als Kreisscheibe wie zentraler Bohrung für den Durchtritt
des Strahls günstig. Die Scheibe dreht sich und wird z. B. durch
Reibungskontakt an der dem Werkstück abgewandten Seite gekühlt.

Auch beim Verschweißen dickwandiger Teile aus unterschiedlichem
Material ist die Erfindung besonders vorteilhaft anwendbar.
Sofern die dickwandigen Teile unterschiedliche Thermospannungen
aufweisen (wie z. B. zwischen ferritischem und austenitischem
Stahl),können sich nahe dem Schweißbad große Thermoströme ausbilden, deren Magnetfeld auf den Strahl störend einwirkt, insbesondere in dem vor der Werkstückoberfläche liegenden Bereich
bevor der Strahl auf das Werkstück trifft. Die entsprechende
Strahlablenkung erfolgt bevorzugt in der Ebene quer zur Nahtrichtung und kann so zu Bindefehlern führen. Da die Temperaturverteilung in der Umgebung des Schweißbades von der Werkstückgeometrie und der Führung des Schweißprozesses abhängt, ist
besagte Strahlablenkung nicht zeitlich konstant. Daher kann
eine Kompensation durch entsprechende Kippung der Strahlrichtung
(vor dem Eintritt des Strahls ins Werkstück) nur teilweise
Abhilfe bringen. Daher ist die erfindungsgemäß vorgeschlagene
magnetische Abschirmung des Strahls vorteilhaft,vorzugsweise
in Kombination mit einer Strahlkippung.

Be/Ha

...

Ansprüche

1. Verfahren zur Magnetfeldabschirmung am Werkstück beim Elektronenstrahlbearbeiten, insbesondere Elektronenstrahlschweißen,
   dadurch gekennzeichnet,
   daß in geringem Abstand einerseits von der vom Strahl getroffenen Werkstückoberfläche und vorzugsweise andererseits vom Elektronenstrahl eine Platte aus ferromagnetischem Material angeordnet wird.

2. Verfahren nach Anspruch 1,
   dadurch gekennzeichnet,
   daß das ferromagnetische Material weichmagnetisch ausgebildet wird.

3. Verfahren nach Anspruch 1 und Anspruch 2,
   dadurch gekennzeichnet,
   daß die Platte band- oder kreisförmig ausgebildet und beim Schweißen gegenüber der Werkstückoberfläche bewegt wird.

4. Verfahren nach einem der Ansprüche 1 bis 3,
   dadurch gekennzeichnet,
   daß insbesondere beim Verschweißen dickwandiger Werkstücke aus unterschiedlichem Material zusätzlich eine Strahl-kippung vorgenommen wird.

Be./Ha

0149004

EB

Naht-
Querschliff

Material A

Abschirmblech

Material B

FIG. 1

EB

FIG. 2

FIG. 3

Wasserkühlung

FIG. 4